# EUROPEAN PATENT SPECIFICATION

(11) **EP 2 412 670 B1**
(45) Date of publication and mention of the grant of the patent: **01.06.2016**
(21) Application number: 10755951.0
(22) Date of filing: 17.03.2010
(51) Int. Cl.: C01B 31/04

(54) **METHOD FOR PRODUCING GRAPHENE FILM, METHOD FOR MANUFACTURING ELECTRONIC ELEMENT, AND METHOD FOR TRANSFERRING GRAPHENE FILM TO SUBSTRATE**
VERFAHREN ZUR HERSTELLUNG EINER GRAPHENFOLIE, VERFAHREN ZUR HERSTELLUNG EINES ELEKTRONISCHEN ELEMENTS UND VERFAHREN ZUR ÜBERTRAGUNG DER GRAPHENFOLIE AUF EIN SUBSTRAT
PROCÉDÉ DE PRODUCTION D'UN FILM DE GRAPHÈNE, PROCÉDÉ DE FABRICATION D'UN ÉLÉMENT ÉLECTRONIQUE, ET PROCÉDÉ DE TRANSFERT D'UN FILM DE GRAPHÈNE SUR UN SUBSTRAT

(30) Priority: 27.03.2009 JP 2009080307
(43) Date of publication of application: 01.02.2012
(73) Proprietor: Japan Science and Technology Agency, Kawaguchi-shi Saitama 332-0012 (JP)
(72) Inventor: FUJITA Jun-ichi, Sakuragawa-shi Ibaraki 309-1243 (JP)
(74) Representative: Calamita, Roberto
(86) International application number: PCT/JP2010/054602
(87) International publication number: WO 2010/110153

(56) References cited:
- JP-A- 4 209 781
- JP-A- 8 097 102
- JP-A- 2005 045 188
- JP-A- 2006 073 388
- JP-A- 2008 037 742
- JP-A- 2009 062 247
- JP-A- 2010 037 128
- JP-A- 2010 052 972
- JP-T- 2005 519 844
- KR-A- 20090 029 621
- REINA A ET AL: "Large area, few-layer graphene films on arbitrary substrates by chemical vapor deposition", NANO LETTERS JANUARY 2009 AMERICAN CHEMICAL SOCIETY US, vol. 9, no. 1, January 2009 (2009-01), pages 30-35, XP002727806, DOI: 10.1021/NL801827V
- KEUN SOO KIM ET AL: "Large-scale pattern growth of graphene films for stretchable transparent electrodes", NATURE, NATURE PUBLISHING GROUP, UNITED KINGDOM, vol. 457, no. 7230, 5 February 2009 (2009-02-05), pages 706-710, XP008127462, ISSN: 0028-0836, DOI: 10.1038/NATURE07719 [retrieved on 2009-01-14]
- PAN ZHENG WEI ET AL: "Gallium-mediated growth of multiwall carbon nanotubes", APPLIED PHYSICS LETTERS, AMERICAN INSTITUTE OF PHYSICS, US, vol. 82, no. 12, 24 March 2003 (2003-03-24), pages 1947-1949, XP012033602, ISSN: 0003-6951, DOI: 10.1063/1.1563727
- FUJITA JUN-ICHI ET AL: "Inducing graphite tube transformation with liquid gallium and flash discharge", APPLIED PHYSICS LETTERS, AMERICAN INSTITUTE OF PHYSICS, US, vol. 88, no. 8, 22 February 2006 (2006-02-22), pages 83109-083109, XP012083000, ISSN: 0003-6951, DOI: 10.1063/1.2178195
- RYUICHI UEKI ET AL.: 'Ekitai Ga Shokubai o Mochiita Amorphous Carbon Kaimen ni Okeru Graphite-ka Hanno' EXTENDED ABSTRACTS; THE JAPAN SOCIETY OF APPLIED PHYSICS vol. 69, no. 1, 02 September 2008, page 421, XP008166889

## Description

### [Technical Field]

The present invention relates to graphene film producing methods, electronic element manufacturing methods, and methods for transferring a graphene film to a substrate.

### [Background Art]

Graphene has various specific properties owning to its ideal two-dimensional structure, including, for example, good conductivity, and high electron and hole mobility. Other properties of graphene, such as inelastic electron conductivity and spin transport, mechanical strength, light absorption and emission, and heat conduction, have also attracted interest. Indeed, graphene is a material having potential in industrial applications in many fields.

At present, various graphene producing methods are known, including a detaching method from pyrolytic graphite crystal, a solid-phase reaction method, and a chemical vapor deposition method.

Graphene was first discovered by Novoselov and others, who detached graphite crystals with a Scotch tape and transferred them onto a SiO₂ substrate. Despite the small size of graphene crystals measuring only about several microns, graphene films can easily be obtained with relatively good reproducibility (Non-Patent Documents 1 and 2).

In the solid-phase reaction method, silicon carbide crystals are subjected to a vacuum heat treatment at about 1,500°C to evaporate the surface Si element (silicon sublimation) and form a graphene crystal layer on a silicon carbide surface (Non-Patent Documents 3 to 7).

In the vapor-phase growth method, the raw material hydrocarbon gas is fed to grow a graphene film on a crystal surface of metals such as nickel and iron using a thermal CVD method (Non-Patent Documents 8 and 9).
[Non-Patent Document 1] Novoselov, K. S. et al., Electric field effect in atomically thin carbon films, Science 306 (2004) 666-669.
[Non-Patent Document 2] Meyer JC, et al., The structure of suspended graphene sheets, Nature. 446(7131) (2007) 60-63.
[Non-Patent Document 3] A. J. van Bommel, et al., A. LEED and Auger electron observations of the SiC(0001) surface, Surf. Sci. 48 (1975) 463-472.
[Non-Patent Document 4] I. Forbeaux et al. Heteroepitaxial graphite on 6H-SiC(0001): Interface formation through conduction-band electronic structure, Phys. Rev. B 58 (1998) 16396-16406.
[Non-Patent Document 5] Berger, C. et al. Ultrathin epitaxial graphite: 2D electron gas properties and a route toward graphene-based nanoelectronics, J. Phys. Chem. B, 108, (2004) 19912-19916.
[Non-Patent Document 6] Berger, C. et al., Electronic confinement and coherence in patterned epitaxial grapheme", Science 312, (2006) 1191-1196.
[Non-Patent Document 7] Ohta, T. et al., Controlling the electronic structure of bilayer graphene, Science 313 (2006) 951 - 954.
[Non-Patent Document 8] T. A. Land, et al., STM investigation of single layer graphite structures produced on Pt(111) by hydrocarbon decomposition", Sur. Sci. 264 (1992) 261-270.
[Non-Patent Document 9] A. Nagashima et al., Electronic states of monolayer graphite formed on TiC(111) surface, Surf. Sci. 291 (1993) 93-98.

KR 20090029621 A discloses a method of preparing a graphene pattern by forming a graphitizing catalyst pattern on a substrate, contacting a carbonaceous material with the graphitizing catalyst and heat-treating in an inert or reductive atmosphere.

### [Disclosure of Invention]

### [Problems that the Invention is to Solve]

However, while the foregoing conventional methods enable formation of a graphene film, obtaining a true monolayer graphene is very difficult. For example, the graphene film produced by the thermal CVD vapor-phase growth method is more of a laminate of several ten layers.

Another problem is that it is also very difficult to isolate the synthesized graphene from the matrix and move it onto an element substrate of a material such as silicon.

Further, disposing graphene at a desired position in a desired direction represents an important technical challenge in using graphene as a part of components such as electronic devices, sensors, and wires. The foregoing conventional methods cannot effectively accommodate such a technical challenge.

All of these problems arise from the great difficulty in obtaining a large-area graphene film, as evidenced by the fact that the formation of the conventional graphene element is based on the graphene film found through the accidental retransfer from the pyrolytic graphite crystals detached with a Scotch tape as in the previous reports. Another big factor is that the transfer position cannot be freely controlled because of large variation in the size and uniformity of the detached graphene itself. Further, because graphene is inherently a single atom layer of six-membered carbon rings of an ultimate thickness, handling of a large-area film involves fundamental and principle difficulties.

The present invention has been made over these backgrounds, and an object of the present invention is to provide a graphene film producing method that enables production of large-area graphene without requiring high temperature.

It is another object of the present invention to provide an electronic element manufacturing method that enables FET circuit patterns to be easily formed on an element substrate using a resist, and that can be easily applied to an area-increasing process by integrating elements.

Yet another object of the present invention is to provide a method for transferring a graphene film to a substrate, whereby a large-area graphene film can be isolated, and a graphene film of a desired size can be transferred to a desired position of a substrate.

### [Means for Solving the Problems]

In order to solve the foregoing problems, the present invention is characterized by the following.
(1) A method for producing a graphene film,
   the method comprising the step of contacting an amorphous carbon film to liquid gallium and applying a vacuum heat treatmentto form a graphene film at the contact interface.
(2) The method according to (1), wherein the amorphous carbon film is a film obtained by carbonizing an organic film into an amorphous form in a vacuum heat treatment.
(3) The method according to (1), wherein the amorphous carbon film is a film obtained by vapor-depositing amorphous carbon on an organic film, and carbonizing the organic film into an amorphous form in a vacuum heat treatment.
(4) A method for manufacturing an electronic element, the method comprising the step of applying a resist onto an element substrate to form a resist pattern that corresponds to an electronic circuit, contacting to the resist pattern liquid gallium, and performing a vacuum heat treatment to convert the resist pattern into graphene and form the electronic circuit.
(5) A method for transferring a graphene film to a substrate,
   the method comprising the step of forming a graphene film at the contact interface between an amorphous carbon film and liquid gallium using the method of any one of (1) to (3), and contacting the amorphous carbon film to a substrate surface to transfer the graphene film to the substrate.
(6) The method according to (5), wherein the substrate is an element substrate.
(7) A method for transferring a graphene film to a substrate,
   the method comprising the steps of:
   forming a graphene film at the contact interface between an amorphous carbon film and liquid gallium using the method of any one of (1) to (3), contacting the amorphous carbon film to a surface of an intermediate medium to transfer the graphene film to the intermediate medium; and
   contacting the graphene film transferred to the intermediate medium to a substrate surface to transfer the graphene film to the substrate.
(8) The method according to any one of (5) to (7), further comprising the step of removing a remaining metal by acid washing from the graphene film transferred to the substrate and/or the intermediate medium.

Metallurgically, gallium (Ga) and carbon (C) do not form an all proportional solid solution. However, near edge X-ray absorption fine structure spectroscopy (NEXAFS) data shows formation of a bond between a gallium atom and a carbon atom. Through the studies of the gallium and carbon reaction process, the present inventors found that formation of large-area graphene is possible by the graphitization reaction induced at the interface between liquid gallium and amorphous carbon at a relatively low temperature of about 1,000°C. The present invention has been completed based on this finding.

It is considered possible to draw an analogy to indium, tin, and antimony based on their properties similar to the properties of gallium.

### [Advantages of the Invention]

The graphene film producing method of the present invention enables production of large-area graphene without requiring high temperature. Specifically, by contacting the raw material amorphous carbon film to a surface of liquid gallium, the amorphous carbon film can easily be transferred to the liquid gallium surface. A large-area graphene film can be formed at the contact portion with the surface of liquid gallium by performing a vacuum heat treatment at about 1,000°C for the amorphous carbon film transferred to the liquid metal surface.

The electronic element manufacturing method of the present invention enables a resist FET circuit pattern to be easily formed on an element substrate, and can easily be applied to an area-increasing process by integrating elements.

The graphene film transfer method of the present invention enables the graphene film formed as above to be transferred to a desired position of a substrate such as an element substrate, and can thus form a large-area graphene film on the substrate.

The graphene film formed as above on a surface of liquid gallium may be transferred to an intermediate medium such as an organic silicon resin, and the graphene film transferred to the intermediate medium may be contacted to a substrate surface. In this way, the graphene film can be transferred to a desired position of a substrate such as an element substrate to obtain a large-area graphene film on the substrate.

### [Brief Description of Drawings]

FIG. 1 is a diagram explaining the step of synthesizing an amorphous carbon film used as the raw material of a graphene film.
FIG. 2 is a diagram explaining the step of vapor-depositing amorphous carbon on an organic film.
FIG. 3 represents photographic images before the vacuum heat treatment of the amorphous carbon film transferred to a liquid gallium surface (left), and after the vacuum heat treatment (right).
FIG. 4 is a schematic diagram of a graphene film held to liquid gallium by floating thereon.
FIG. 5 is a high-resolution transmission electron micrograph of a free film scooped with a transmission electron microscopy mesh after removing liquid gallium from the surface of a graphene film formed on one side of an amorphous carbon film (the side in contact with the gallium) and placed into dilute hydrochloric acid with the gallium.
FIG. 6 represents a transmission electron micrograph of bent portions of a graphene film on a transmission electron microscopy mesh, and a selected area diffraction image (bottom left).
FIG. 7 represents a transmission electron micrograph of bent portions of a graphene film on a transmission electron microscopy mesh.
FIG. 8 is a diagram explaining the step of transferring a graphene film onto an element substrate using an organic silicon resin.
FIG. 9 represents photographic images of a graphene film formed on a gallium surface and transferred in contact with a PDMS sheet; (a), after the transfer; (b), after the removal of gallium by a dilute hydrochloric acid treatment.
FIG. 10 represents high-resolution TEM images and Raman spectra of multilayer graphene ((a), amorphous carbon film thickness = 15 nm, heat treatment temperature = 1,000°C; (b), amorphous carbon film thickness = 8 nm, heat treatment temperature = 1,000°C; (c), amorphous carbon film thickness = 3 nm (Formvar film only), heat treatment temperature = 1,000°C; (d), amorphous carbon film thickness = 3 nm (only Formvar film), heat treatment temperature = 1,100°C).
FIG. 11 represents a typical device structure produced in Example, and a photographic image thereof.
FIG. 12 represents the source-drain I-V characteristics (I_{SD}-V_{SD} characteristics) and other information of a device produced in Example.
FIG. 13 represents the source-drain I-V characteristics (I_{SD}-V_{SD} characteristics) and other information of a device produced in Example.
FIG. 14 represents graphene FET producing steps.
FIG. 15 represents an optical micrograph of the channel pattern after the electron beam exposure of a 400 nm-thick NEB resist (upper left photograph), and an optical micrograph of an FET channel device produced by converting the resist pattern into graphene and fabricating source-drain electrodes from gold (bottom left photograph); the graphs on the right-hand side represent the corresponding FET characteristics.

### [Description of Reference Numerals and Signs]

- 1: Organic film solution droplet
- 2: Distilled water
- 3: Organic film
- 4: Ceramic ring
- 5: Carbon raw material for ablation
- 6: YAG laser
- 7: Amorphous carbon film
- 8: Liquid gallium
- 9: Amorphous carbon film transferred to liquid gallium surface
- 10: Synthesized graphene film
- 11: Unreacted amorphous carbon film
- 12: Organic silicon resin
- 13: Graphene film transferred to organic silicon resin surface
- 14: Element substrate

### [Best Mode for Carrying Out the Invention]

An embodiment of the present invention is described below with reference to the accompanying drawings. Note that descriptions will be given through the case where the metal is gallium.

In the graphene film producing method of the present invention, an amorphous carbon film of a several nanometer thickness with a diameter of, for example, several millimeters to several centimeters is synthesized as the raw material of the target graphene film.

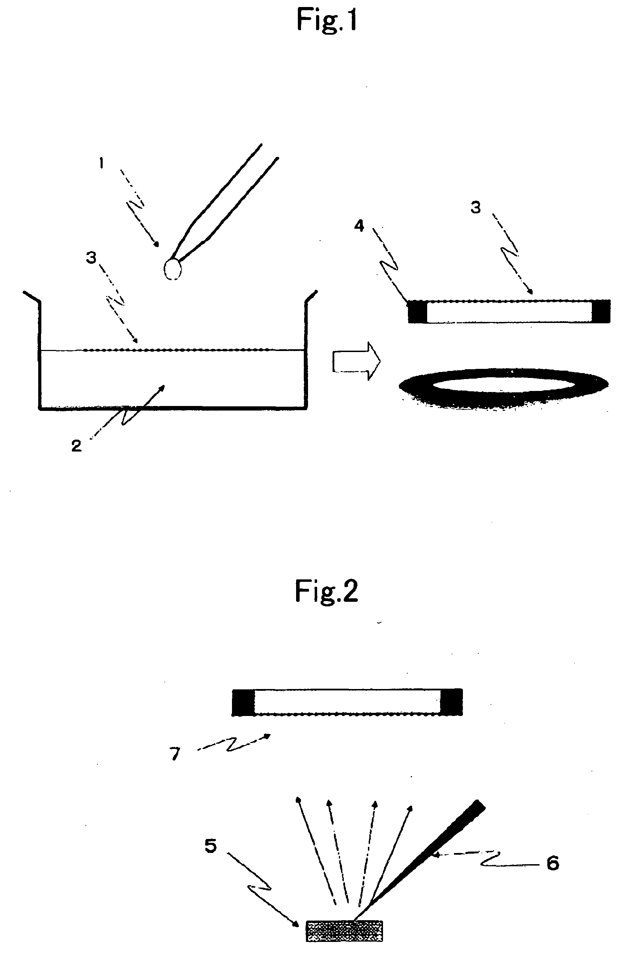

First, an organic film such as a collodion film and a Formvar film is formed as the raw material of the amorphous carbon film. For example, as illustrated in FIG. 1, a solution droplet 1 of an organic film such as a collodion film and a Formvar film is dropped on distilled water 2 to obtain an organic film 3 of an extremely thin thickness on the water surface. Typically, the organic film 3 can be obtained in a thickness of about 30 nm with a 5% collodion solution.

Scooping the organic film 3 with a ceramic ring 4 such as alumina enables the organic film 3 to be stretched over the ceramic ring 4.

Aside from the collodion film and Formvar film, various organic films of several nanometer thickness can be used as the organic film, depending on the intended use. For example, resist materials such as a LB (Langmuir-Blodgett) film, and a PMMA (polymethylmethacrylate) film may be used. As an example, a mesh with a stretched collodion film or Formvar film of several nanometer thickness is used as a sample retaining film for transmission electron microscopy.

Then, the organic film is subjected to a vacuum heat treatment to carbonize it into an amorphous form and synthesize the amorphous carbon film. For example, a ceramic ring with the stretched organic film is subjected to a vacuum heat treatment at 500°C for 30 minutes to decompose and modify the organic film into carbon.

In the present invention, amorphous carbon may be vapor-deposited on the organic film to improve the evenness and strength of the amorphous carbon film. For example, as illustrated in FIG. 2, a solid carbon target of a carbon raw material 5 for ablation is subjected to laser ablation using an infrared pulse YAG laser 6 to coat the organic film with an amorphous carbon film 7. The organic film coated with the amorphous carbon film 7 can then be subjected to a vacuum heat treatment to decompose and modify the organic film into carbon. Here, the amorphous carbon film 7 substantially maintains its shape as a film even after the vapor deposition, and an amorphous carbon film with improved overall evenness and strength can be obtained.

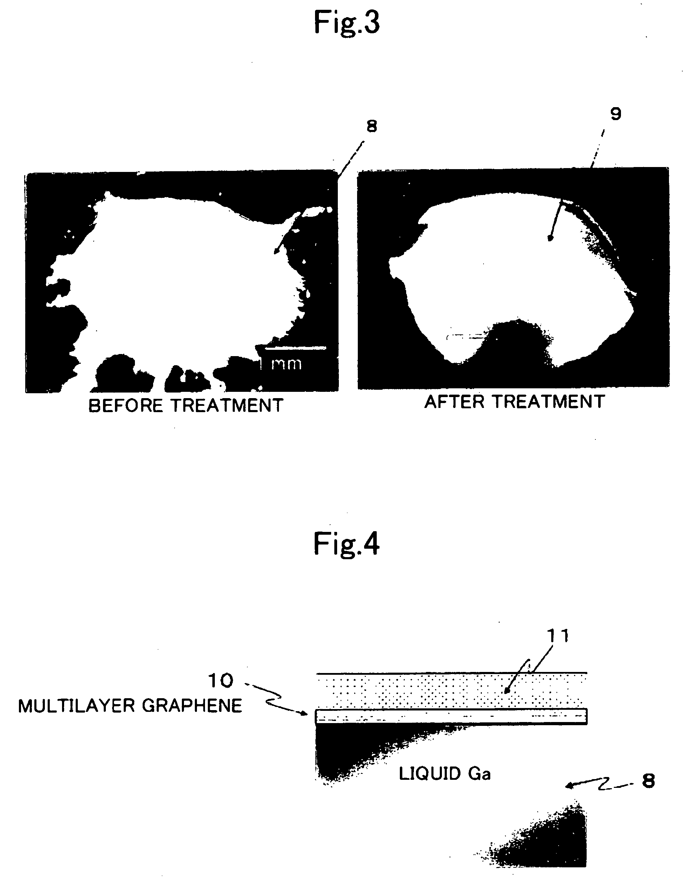

The amorphous carbon film so obtained is then transferred by being contacted to the surface of liquid gallium, and subjected to a heat treatment in a vacuum. For example, as shown in the photograph on the left-hand side of FIG. 3, the ceramic ring with the stretched amorphous carbon film is brought into contact with the top surface of liquid gallium 8. Here, the liquid gallium is retained in an alumina crucible for a later graphene reaction step. At the surface of the alumina crucible, the liquid surface assumes a convex shape by the very strong surface tension of the liquid gallium. The amorphous carbon film is transferred to this convex liquid surface of the liquid gallium surface. In the photographs of FIG. 3, the transferred amorphous carbon film has a diameter of about 3 mm. However, an amorphous carbon film with a diameter of several centimeters also can be transferred relatively easily.

The amorphous carbon film is subjected to a vacuum heat treatment after being contacted and transferred to the liquid gallium surface. For example, the heat treatment is performed in a vacuum at 1,000°C for about 10 to 30 minutes to form graphene at the contact interface between the liquid gallium and the amorphous carbon film.

Because the vapor pressure of gallium is about 10⁻⁴ Pa at 1,000°C, the gallium gradually evaporates during the vacuum heat treatment. However, a single graphene synthesis reaction involves only small amounts of evaporation. For industrial applications, the graphene may be synthesized under quality management by controlling the evaporation amounts with a closed circuit formed in the reaction tube.

The photograph on the right-hand side of FIG. 3 represents the result of a 1,000°C, 30-min vacuum heat treatment after cooling to room temperature. It can be seen that, despite the 1,000°C reaction, an amorphous carbon film 9 remains on the liquid gallium with the maintained shape of the original amorphous carbon film before the vacuum heat treatment.

FIG. 4 shows a schematic illustration of the graphene film held to the liquid gallium by floating thereon. A graphene film 10 is formed at the contact interface with the liquid gallium 8, and an unreacted amorphous carbon film 11 remains on the graphene film 10.

In this manner, the graphene film 10 is formed at the contact interface with the gallium in a portion of the raw material amorphous carbon film 11, and the amorphous carbon film 11 remains even after the reaction. The remains of the amorphous carbon film 11 reinforce the graphene film 10, and thus serves an important role in preventing damage to the large-area graphene film 10 during the transfer to a substrate.

The graphene film obtained as above may be transferred to a substrate. For example, the amorphous carbon film and the gallium with the graphene film formed at the contact interface may be directly used to contact the amorphous carbon film to a substrate surface and transfer the graphene film to the substrate.

An element substrate, such as silicon with an oxide film, may be used as the substrate. For example, the graphene film may be transferred onto the surface of the silicon oxide film, or to the electrode surface on the element substrate. When the graphene film is used as the electrode of the element substrate or as a part of the electrode, the graphene side may be placed on the electrode surface of the element substrate, or on the surface of the element substrate. This offers freedom in the post-processing of the film and in electrode formation, for example.

Because the graphene film has higher etching resistance to oxygen plasma or the like than the amorphous carbon, the excess amorphous carbon film may be removed by heat treatment in an oxygen plasma or in an oxygen atmosphere.

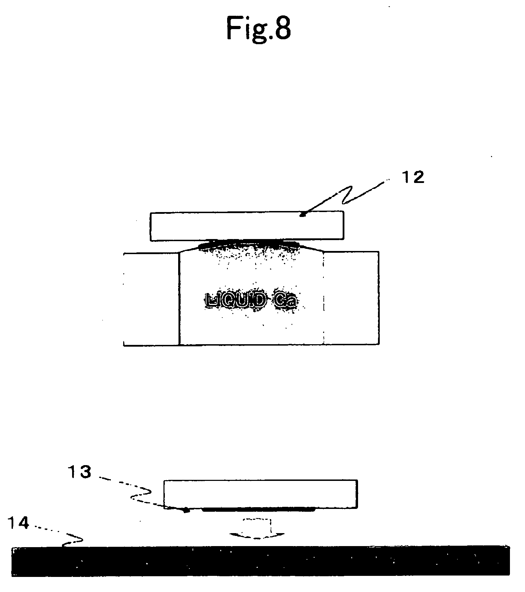

Alternatively, after forming the graphene film at the contact interface between the amorphous carbon film and the gallium, the amorphous carbon film may be contacted to a surface of an intermediate medium to transfer the graphene film to the intermediate medium, and the graphene film transferred to the intermediate medium may be contacted and transferred to a substrate surface. For example, as illustrated in FIG. 8, while the amorphous carbon film is highly adherent to the surface of an organic silicon resin 12 such as PDMS (polydimethylsiloxane) resin, the liquid gallium has very poor wettability for the organic silicon resin 12. The graphene film floating on the liquid gallium can be transferred to the surface of the organic silicon resin 12 by taking advantage of these properties. The liquid gallium partially remaining on the graphene film 13 transferred to the organic silicon resin 12 can be removed from the graphene film by being treated with an acid such as dilute hydrochloric acid. The graphene film 13 transferred to the surface of the organic silicon resin 12 can then be retransferred to the element substrate 14 in, for example, a stamping fashion.

In the indirect transfer to an intermediate medium such as an organic silicon resin, the graphene film exists on the substrate surface on the element substrate. An electronic circuit pattern may be formed over this graphene film by using a method such as a resist process to synthesize a graphene element.

In the present invention, the electronic element also may be manufactured as follows. First, a resist is applied to the element substrate to form a resist pattern that corresponds to the electronic circuit. This step may be performed by using a conventionally known method that uses an organic material resist, for example, such as a chemical amplification resist.

The liquid gallium is then contacted to the resist pattern, and a vacuum heat treatment is performed to convert the resist pattern into graphene and form the electronic circuit. Specifically, the resist pattern is directly covered with the liquid gallium, and the resist pattern is converted into graphene by a vacuum heat treatment performed under the foregoing conditions.

A big advantage of this technique is that it enables a resist channel of about 10-nm width to be very easily formed in the original resist pattern based on the conventional technique. In common graphene film transfer methods, etching and other processes need to be performed after forming the channel pattern by exposure to an electron beam following the application of a resist to the graphene film transferred onto a silicon oxide film. However, there is a concern about processing damages to the graphene channel itself and to the edge portions. In contrast, the foregoing method forms graphene at the contact portion with the liquid gallium, and thus enables a resist FET circuit pattern to be easily formed on an element substrate such as a silicon substrate. The method can thus be easily applied to an area-increasing process by integrating elements.

In the foregoing embodiment, a homogeneous graphene film is produced at the contact interface between the amorphous carbon structure (film) and the liquid gallium. The size of the graphene film and the number of graphene layers are accurately controlled, and thus the graphene film can sufficiently exhibit the desirable properties of graphene, including good conductivity, high-mobility, inelastic electron and spin transport, mechanical strength, good heat conductivity, and light absorption and emission. The graphene film thus has potential application in a variety of functional elements such as electronic elements and spin elements.

### [Examples]

The present invention is described in more detail below based on Examples. It should be noted, however, that the present invention is in no way limited by the following Examples.

### <Example 1>

A graphene film was produced according to the following procedure. First, a 5% collodion solution was dropped over distilled water to obtain a collodion film of an extremely thin thickness on the water surface. The collodion film was scooped with an alumina ceramic ring to form a collodion film of about 30 nm thickness on the ring.

Then, a solid carbon target was subjected to laser ablation using a 1,064 nm pulsed infrared YAG laser to cover the collodion film with an amorphous carbon film of about 10 nm thickness.

The amorphous carbon film-coated ceramic ring was then subjected to a vacuum heat treatment at 500°C for 30 minutes to decompose and modify the collodion film into carbon. After the heat treatment, the amorphous carbon film remained on the ceramic ring in a thickness of about 20 nm.

Thereafter, as shown in the photograph on the left-hand side of FIG. 3, the ceramic ring with the stretched amorphous carbon film of about 3-mm diameter was contacted to the top surface of liquid gallium for transfer. The liquid gallium was retained in an alumina crucible for a later graphene reaction step.

The amorphous carbon film transferred to the liquid gallium surface was then subjected to a heat treatment in a vacuum at 1,000°C. The photograph on the right-hand side of FIG. 3 represents the result of the 1,000°C, 30-min reaction after cooling to room temperature. It can be seen that, despite the 1,000°C reaction, the film remained on the liquid gallium with the maintained shape of the original amorphous carbon film.

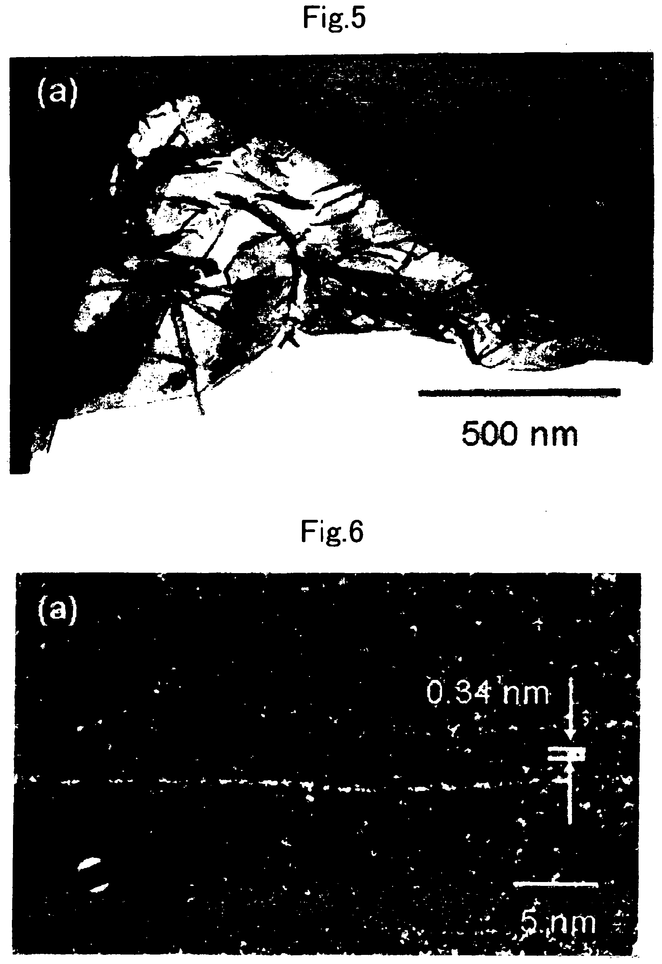

The graphene film formed on one side of the amorphous carbon film (the side in contact with the gallium) was placed in dilute hydrochloric acid with the gallium, and the liquid gallium was separated from the graphene surface to free the film. The film was then scooped with a mesh for transmission electron microscopy (TEM), and observed in a high resolution image (FIG. 5). The film was bent and segmented in the course of liberation in the dilute hydrochloric acid. This was inevitable for TEM observation. In actual application to device production, the graphene film remains as a film by being retransferred onto a substrate.

Many bends were observed in the film placed on the TEM sample mesh. Observing a graphene film in the monolayer state is very difficult, and, in many cases, several graphene layers exist as a laminate. At the bent portions on the TEM sample mesh, the C axis of the graphene is orthogonal to the TEM electron beam. This is very convenient in observing the graphene laminate structure in a TEM image. As shown in FIG. 6, four.to five layers of graphene are synthesized in an orderly fashion. It can be seen from the selected area diffraction image (bottom left in FIG. 6) that the graphene laminate interval is 0.34 nm, based on the appearance of diffraction spots that can be indexed to the diffraction (0002) from the graphite C plane laminate.

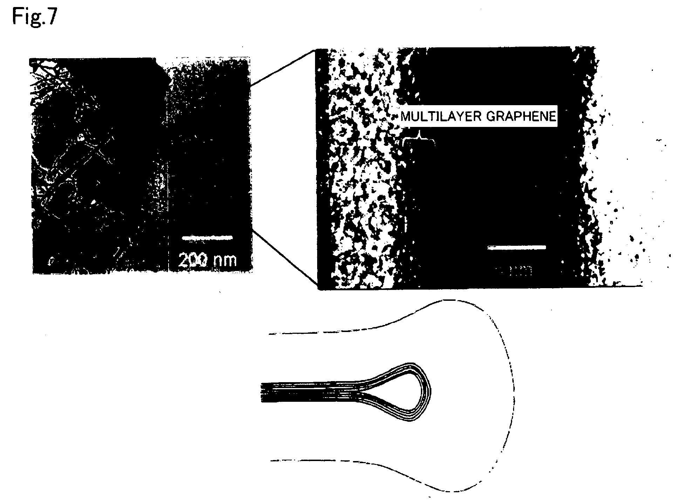

Further, it can be seen in FIG. 7 that the unreacted amorphous carbon film and the graphene produce a contrast at the bent portions of the film, and that the graphene layer and the unreacted amorphous carbon layer are inside and outside, respectively, of the bends in the bent portions.

### <Example 2>

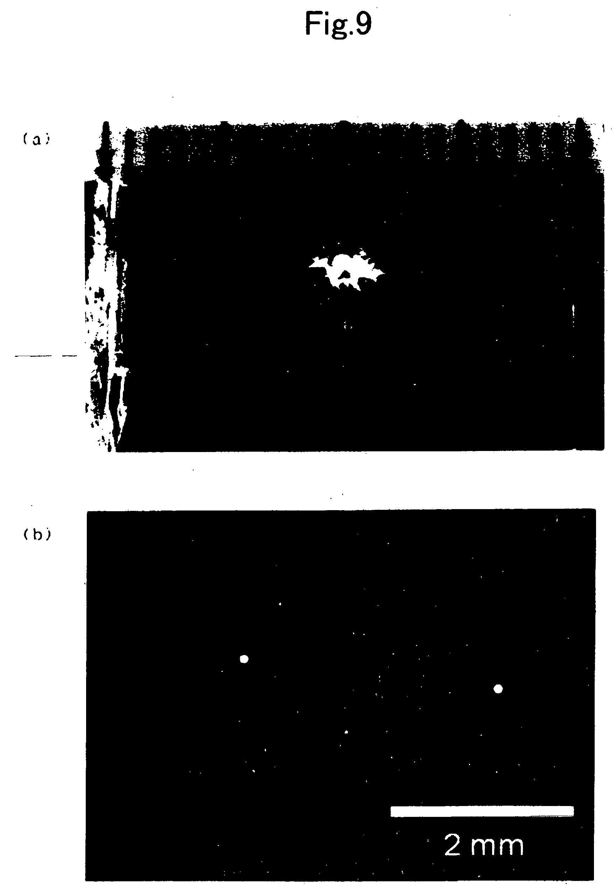

The graphene film formed on the gallium surface according to the procedure of Example 1 was transferred. Upon contacting a PDMS sheet to the graphene film on the gallium surface, the graphene film adhered to the PDMS sheet surface with a part of the gallium (FIG. 9(a)). A dilute hydrochloric acid treatment of the gallium adhered to the surface with the graphene film detached the gallium, leaving a film on the PDMS sheet surface, as shown in the photograph in FIG. 9(b).

### <Example 3>

### Changes in Crystallinity with Amorphous Carbon Film Thickness

The amorphous carbon film obtained in the same manner as in Example 1 was contacted to liquid gallium, and a heat treatment was performed in a 5 × 10⁻⁴ Pa vacuum at 1,000°C or 1,100°C for 30 minutes to form four- to six-layer graphene at the contact interface between the amorphous carbon and the liquid gallium.

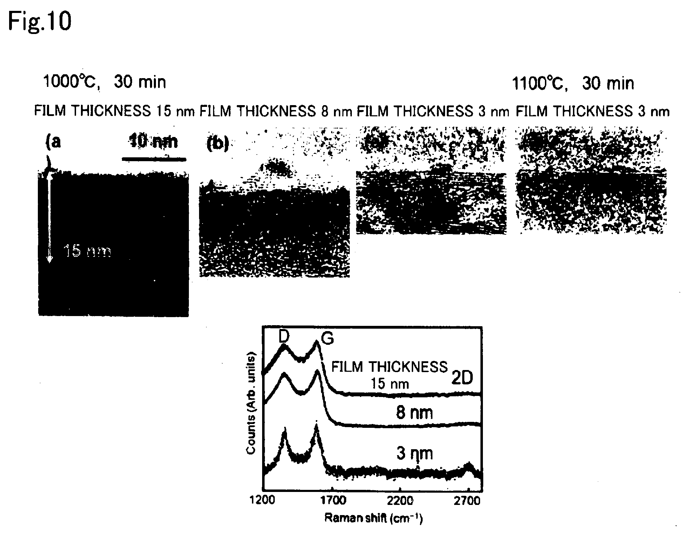

FIG. 10 represents high-resolution TEM images and the Raman spectra of the multilayer graphene ((a), amorphous carbon film thickness = 15 nm, heat treatment temperature = 1,000°C; (b), amorphous carbon film thickness = 8 nm, heat treatment temperature = 1,000°C; (c), amorphous carbon film thickness = 3 nm (Formvar film only), heat treatment temperature = 1,000°C; (d), amorphous carbon film thickness = 3 nm (Formvar film only), heat treatment temperature = 1,100°C).

The crystallinity of the graphene film varied with changes in the thickness of the amorphous carbon deposited by laser ablation prior to forming graphene, and the graphene crystallinity had the tendency to improve as the amorphous carbon thickness was reduced from 15 nm to 3 nm.

### <Example 4>

### Electric Field Effect Characteristics of Graphene Film

The graphene obtained in Example 3 was transferred to a Si substrate that had a 300-nm oxide film, and a Ti/Au electrode was produced with a stencil mask to produce a back gate structure.

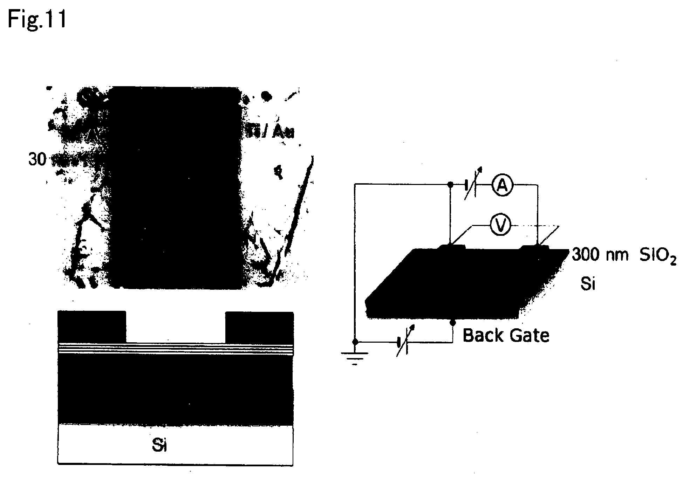

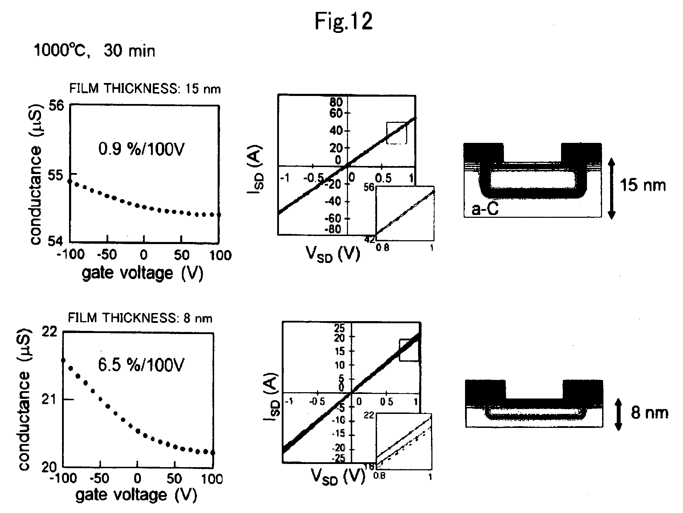

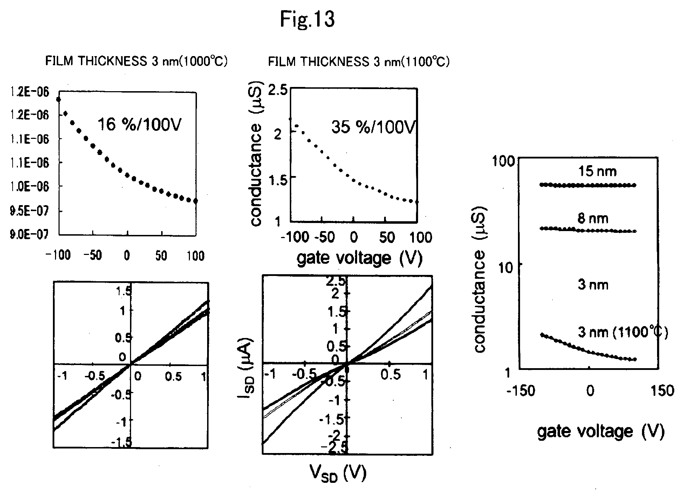

FIG. 11 represents a typical device structure produced in this manner. FIGS. 12 and 13 represent the source-drain I-V characteristics (I_{SD}-V_{SD} characteristics) along with other information. In the I_{SD}-V_{SD} characteristics of the graphene, there were clear SD conductance changes in response to the applied gate voltage of -100 to +100 V, and conductance was modulated at the maximum of 40%.

The minimum conductance value greatly shifted toward the positive bias side, and p-type behavior was observed in the characteristics (inserts in FIGS. 12 and 13).

Further, the conductance decreased and the rate of change improved with decrease in amorphous carbon thickness. It is considered that the presence of the remaining amorphous layer behind the graphene has large influence on graphene device operation.

Specifically, there were only small changes in the slope of source-drain I-V characteristics with the 15 nm thickness, and changes in SD conductance in response to the gate voltage change from +100 V to -100 V was only about 1%. The conductance modulation increased to 6.5% with the 8-nm amorphous carbon film thickness. The conductance modulation was 16% in the 3 nm-thick amorphous carbon (Formvar film formed by pyrolysis without the laser deposition of amorphous carbon), and an FET element with clear 35% conductance modulation was produced at the graphite reaction temperature of 1,100°C.

By comparing the conductance characteristics of the four FET elements, it can be said that the conductance is very large for the 15-nm thickness; specifically, the channel resistance value is very small. Thinner channels mean lower conductances (higher channel resistances), and the degree of modulation increases at the same time. To be more specific, the presence of amorphous carbon underneath the 4- to 6-layer graphene increases the conductance by the channel current that flows through it, and, because the graphene film floating on Ga is directly transferred to the Si substrate, a low-resistance amorphous carbon layer exists immediately above the gate oxide film. It is considered that the low-resistance amorphous carbon layer influences the modulation characteristics by blocking (screening) the electric field applied by the gate, and by lowering the effective electric field strength applied to the graphene channel.

### <Example 5>

### Graphitization of Resist Pattern on Si Substrate

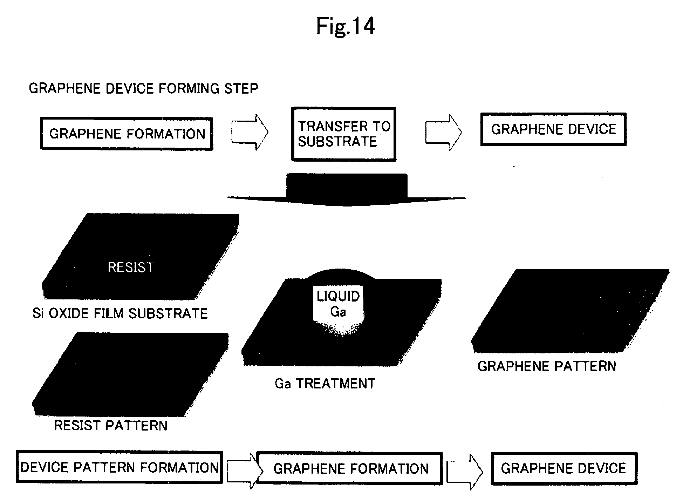

A graphene FET was produced in the steps illustrated in FIG. 14. A thin layer (about 10 nm) of a resist (chemical amplification NEB negative resist) was applied over a silicon oxide film, and an FET channel pattern and an electronic circuit pattern were formed by electron beam lithography.

Liquid gallium was directly placed on the resist pattern, and a vacuum heat treatment was performed to convert the whole resist pattern into graphene.

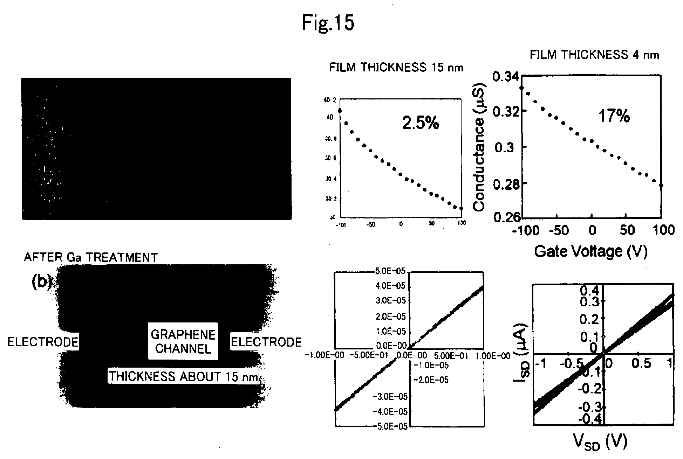

FIG. 15 represents a light micrograph of the channel pattern after the electron beam exposure of a 400 nm-thick NEB resist (upper left photograph), and an optical micrograph of an FET channel device produced by converting the resist pattern into graphene and fabricating source-drain electrodes from gold (bottom left photograph). The graphs on the right-hand side of FIG. 15 represent the corresponding FET characteristics. The FET characteristics improved with decrease in resist pattern thickness, and an FET element was formed that had 17% conductance modulation with a 4-nm resist channel pattern.

## Claims

1. A method for producing a graphene film,
the method comprising the step of contacting an amorphous carbon film to liquid gallium and applying a vacuum heat treatment to form a graphene film at the contact interface.

2. The method according to claim 1, wherein the amorphous carbon film is a film obtained by carbonizing an organic film into an amorphous form in a vacuum heat treatment.

3. The method according to claim 1, wherein the amorphous carbon film is a film obtained by vapor-depositing amorphous carbon on an organic film, and carbonizing the organic film into an amorphous form in a vacuum heat treatment.

4. A method for manufacturing an electronic element,
the method comprising the step of applying a resist onto an element substrate to form a resist pattern that corresponds to an electronic circuit, contacting liquid gallium and performing a vacuum heat treatment to convert the resist pattern into graphene and form the electronic circuit.

5. A method for transferring a graphene film to a substrate,
the method comprising the step of forming a graphene film at the contact interface between an amorphous carbon film and liquid gallium using the method of any one of claims 1 to 3, and contacting the amorphous carbon film to a substrate surface to transfer the graphene film to the substrate.

6. The method according to claim 5, wherein the substrate is an element substrate.

7. A method for transferring a graphene film to a substrate,
the method comprising the steps of:
forming a graphene film at the contact interface between an amorphous carbon film and liquid gallium using the method of any one of claims 1 to 3, contacting the amorphous carbon film to a surface of an intermediate medium to transfer the graphene film to the intermediate medium; and
contacting the graphene film transferred to the intermediate medium to a substrate surface to transfer the graphene film to the substrate.

8. The method according to any one of claims 5 to 7, further comprising the step of removing a remaining metal by acid washing from the graphene film transferred to the substrate and/or the intermediate medium.

## Patentansprüche

1. Verfahren zum Herstellen eines Graphenfilms, das Verfahren umfassend die Schritte
Kontaktieren eines amorphen Kohlenstofffilms mit flüssigem Gallium und
Anwenden einer Vakuumwärmebehandlung, um einen Graphenfilm an der Kontaktgrenzfläche zu bilden.

2. Verfahren nach Anspruch 1, wobei der amorphe Kohlenstofffilm ein Film ist, der durch Karbonisieren eines organischen Films in eine amorphe Form während einer Vakuumwärmebehandlung erhalten wird.

3. Verfahren nach Anspruch 1, wobei der amorphe Kohlenstofffilm ein Film ist, der durch Dampfabscheiden von amorphem Kohlenstoff auf einem organischen Film und durch Karbonisieren des organischen Films in eine amorphe Form während einer Vakuumwärmebehandlung erhalten wird.

4. Verfahren zum Herstellen eines elektronischen Elements, das Verfahren umfassend die Schritte
Auftragen eines Abdecklacks auf ein Elementsubstrat, um ein Lackmuster zu bilden, das einem elektronischen Schaltkreis entspricht,
Kontaktieren von flüssigem Gallium und
Ausführen einer Vakuumwärmebehandlung, um das Lackmuster in Graphen umzuwandeln und den elektronischen Schaltkreis zu bilden.

5. Verfahren zum Übertragen eines Graphenfilms auf ein Substrat, das Verfahren umfassend die Schritte
Bilden eines Graphenfilms an der Kontaktgrenzfläche zwischen einem amorphen Kohlenstofffilm und flüssigem Gallium unter Verwendung des Verfahrens nach einem der Ansprüche 1 bis 3 und
Kontaktieren des amorphen Kohlenstofffilms mit einer Substratoberfläche, um den Graphenfilm auf das Substrat zu übertragen.

6. Verfahren nach Anspruch 5, wobei das Substrat ein Elementsubstrat ist.

7. Verfahren zum Übertragen eines Graphenfilms auf ein Substrat, das Verfahren umfassend die Schritte:
Bilden eines Graphenfilms an der Kontaktgrenzfläche zwischen einem amorphen Kohlenstofffilm und flüssigem Gallium unter Verwendung des Verfahrens nach einem der Ansprüche 1 bis 3,
Kontaktieren des amorphen Kohlenstofffilms mit einer Oberfläche eines Zwischenträgers, um den Graphenfilm auf den Zwischenträger zu übertragen, und
Kontaktieren den auf den Zwischenträger übertragenen Graphenfilm mit einer Substratoberfläche, um den Graphenfilm auf das Substrat zu übertragen.

8. Verfahren nach einem der Ansprüche 5 bis 7, weiterhin umfassend den Schritt Entfernen verbleibenden Metalls von dem auf das Substrat und/oder den Zwischenträger übertragenen Graphenfilm mittels Säurewäsche.

## Revendications

1. Procédé de production d'un film de graphène,
le procédé comprenant l'étape de mise en contact d'un film de carbone amorphe avec du gallium liquide et d'application d'un traitement à chaud sous vide pour former un film de graphène à l'interface de contact.

2. Procédé selon la revendication 1, dans lequel le film de carbone amorphe est un film obtenu par carbonisation d'un film organique en une forme amorphe dans un traitement à chaud sous vide.

3. Procédé selon la revendication 1, dans lequel le film de carbone amorphe est un film obtenu par dépôt en phase vapeur de carbone amorphe sur un film organique et carbonisation du film organique en une forme amorphe dans un traitement à chaud sous vide.

4. Procédé de fabrication d'un élément électronique,
le procédé comprenant l'étape d'application d'un résist sur un substrat d'élément pour former un motif de résist qui corresponde à un circuit électronique, de mise en contact avec du gallium liquide et de réalisation d'un traitement à chaud sous vide pour convertir le motif de résist en graphène et former le circuit électronique.

5. Procédé de transfert d'un film de graphène à un substrat,
le procédé comprenant l'étape de formation d'un film de graphène à l'interface de contact entre un film de carbone amorphe et du gallium liquide en utilisant le procédé selon l'une quelconque des revendications 1 à 3 et de mise en contact du film de carbone amorphe avec une surface de substrat pour transférer le film de graphène au substrat.

6. Procédé selon la revendication 5, dans lequel le substrat est un substrat d'élément.

7. Procédé de transfert d'un film de graphène à un substrat,
le procédé comprenant les étapes consistant à :
former un film de graphène à l'interface de contact entre un film de carbone amorphe et du gallium liquide en utilisant le procédé selon l'une quelconque des revendications 1 à 3,
mettre en contact le film de carbone amorphe avec une surface d'un support intermédiaire pour transférer le film de graphène au support intermédiaire ; et
mettre en contact le film de graphène transféré au support intermédiaire avec une surface de substrat pour transférer le film de graphène au substrat.

8. Procédé selon l'une quelconque des revendications 5 à 7, comprenant en outre l'étape de retrait d'un métal résiduaire par lavage à l'acide à partir du film de graphène transféré au substrat et/ou au support intermédiaire.
